Europäisches Patentamt

(19) European Patent Office

Office européen des brevets

(11) Publication number : **0 458 452 B1**

(12) **EUROPEAN PATENT SPECIFICATION**

(45) Date of publication of patent specification :
01.03.95 Bulletin 95/09

(51) Int. Cl.⁶ : **H03D 1/22, H04L 27/22**

(21) Application number : **91303193.6**

(22) Date of filing : **11.04.91**

(54) **Quadrature demodulator.**

(30) Priority : **25.05.90 GB 9011800**

(43) Date of publication of application :
**27.11.91 Bulletin 91/48**

(45) Publication of the grant of the patent :
**01.03.95 Bulletin 95/09**

(84) Designated Contracting States :
**DE FR GB IT SE**

(56) References cited :
**EP-A- 0 428 226
US-A- 4 737 728
US-A- 4 779 054
US-A- 4 849 991
IEEE TRANSACTIONS ON AEROSPACE AND
ELECTRONIC SYSTEMS vol. 30, no. 6, November 1984, NEW YORK, US pages 821 - 824;
RADER, C.M.: 'A SIMPLE METHOD FOR SAMPLING IN-PHASE AND QUADRATURE COMPONENTS'**

(56) References cited :
"**Multirate Digital Signal Processing**",
**R.E.Crochiere & L.R.Rabiner, Prentice-Hall
Inc. US, 1983, pages 70-75**
"**Digital Signal Processing**", **Alan V. Oppenheim et al., Prentice-Hall International, US,
1975, chapter 5, pages 268-9**
**Patent Abstracts of Japan, vol.3, no.40,
(E-102), 14.02.79. & JP-A-54-019347 (Matsushita) 06.04.79.**

(73) Proprietor : **NOKIA MOBILE PHONES (U.K.)
LIMITED
Ashwood House,
Pembroke Broadway
Camberley, Surrey GU15 3SP (GB)**

(72) Inventor : **Ng, Samuel
40 Claremont Road
Bristol BS7 8DH (GB)**

(74) Representative : **Frain, Timothy John
Patent Department
Nokia Mobile Phones
St Georges Court
St Georges Road
Camberley, Surrey GU15 3QZ (GB)**

## Description

This invention relates to a demodulating arrangement for deriving an in-phase (I) and quadrature (Q) output signal from an input radio frequency (RF) signal.

In the field of RF communications it is sometimes required to obtain the base-band signal in a form having I and Q components. For example, the Pan-European Digital Mobile Communications system currently proposed by GSM employs gaussian minimum shift keying (GMSK) modulation. In this case IQ representation is necessary because the GMSK spectrum is asymmetric about the carrier.

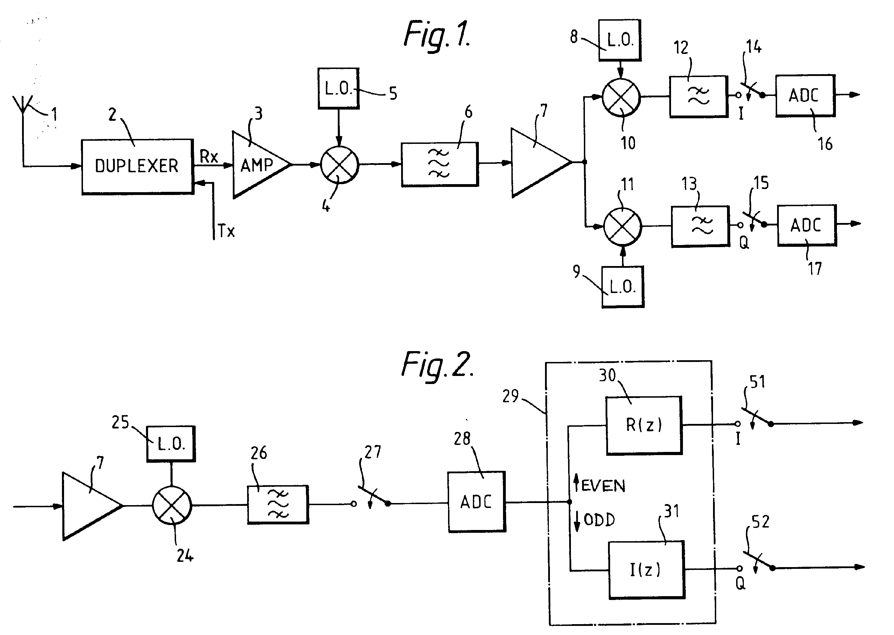

A typical radio receiver front end configuration employing a conventional prior art quadrature demodulator is shown in Figure 1. The RF signal is received by an antenna 1. A duplexer 2 coupled to the antenna 1 passes the receive-band and rejects the transmit band. After low noise amplification at amplifier 3 the signal is then applied to a mixer 4 which mixes the signal down to a fixed intermediate frequency (IF), suitably 45MHz. To this end a locally generated signal having a predetermined frequency is applied to the mixer 4 from frequency synthesizer 5. The output signal is applied to a band pass filter 6 to isolate the required channel. At this stage the swing of the fading envelope is removed or attenuated by a limiter 7 or by automatic gain control. This measure is necessary in order to utilise the whole dynamic range of the analogue to digital converters (ADCs) used subsequently as much and as often as possible.

The base-band signal is obtained in IQ form using a conventional quadrature demodulator. The I and Q channels are obtained in two respective limbs of the demodulation circuit using a respective mixer 10,11 and local oscillator 8, 9 where the signal from local oscillator 9 is phase shifted by 90° with respect to the signal from local oscillator 8. The I and Q channels are separately filtered at filters 12 and 13 respectively, sampled at 14 and 15, and then digitised by ADCs 16 and 17 with, for example, 8 bit resolution (this precision level can be reduced if limiting is always maintained).

The conventional quadrature demodulator described above suffers from the drawback that it is susceptible to imbalances between the non-ideal mixers, filters, samplers and ADCs in the two separate limbs of the circuit associated with the I and Q channels respectively.

With a view to overcoming the problems associated with the conventional quadrature demodulator, the article in 1984 IEEE Communications, pages 821-824 by Charles M. Rader proposes an alternative configuration employing a combination of mixing to a very low IF frequency, sampling and digitising, and then using digital filtering. The complex digital filter used comprises a pair of feedback filter sections associated respectively with the I and Q channels. This so-called infinite impulse response (IIR) filter thus acts as a digital phase splitter. IIRs do however have the drawback that the phase response is non-linear and can suffer distortion.

According to the present invention there is provided a demodulating arrangement for deriving an in-phase (I) and quadrature (Q) output signal from an input radio frequency (RF) signal, comprising RF signal input means for down-converting said RF signal to an intermediate frequency (IF) signal, the value of said intermediate frequency (IF) signal being equal to the data symbol transmission rate, wherein the data symbol transmission rate is the number of data symbols transmitted per unit time by the transmitter, means for sampling said IF signal, said means being adapted to sample the IF signal at an integral multiple of four times the data symbol transmission rate, means for digitising the sampled signal, digital filter means comprising two feedforward filter sections, the digital filter means being adapted to pass a band of frequencies including the positive value of frequency ($+f_o$) corresponding to the frequency ($f_o$) of the IF signal and to attenuate a band of frequencies including the negative value of frequency ($-f_o$) corresponding to the frequency ($f_o$) of the IF signal, and means for applying the digitised signal sample selectively to the two sections of said digital filter means whereby I and Q signals are output from the two filter sections respectively.

It is noted that, as used herein, the term demodulating relates to the technique of deriving in-phase and quadrature samples from an RF input signal and the term quadrature demodulator is used accordingly.

Compared with the conventional quadrature demodulator described above, an arrangement in accordance with the present invention has the advantage that only a single mixer, filter and ADC are employed at the phase splitting and sampling stage. By halving the component count the power consumption can also be significantly reduced. Furthermore, the problem of matching gain and phase response between two components is avoided, since only a single mixer, filter, sampler and ADC need to be utilised. Moreover, in contrast with the arrangement disclosed in the IEEE article cited above, the use of a feedforward filter, specifically a so-called finite impulse response (FIR) filter, enables the filter to have a substantially linear phase response and to be substantially free from phase distortion.

Suitably the digital filter means is adapted to pass a band of frequencies including the positive frequency corresponding to the frequency of the IF signal and to attenuate a band of frequencies including the negative frequency corresponding to the frequency of the IF signal. In this case the result is a complex signal and the complex digital filter can be divided into a real part and an imaginary part corresponding to the I and Q signals respectively.

Also the sampling means is adapted to sample the IF signal at an integral multiple of four times the data symbol transmission rate. Thus the digital filter means splits cleanly into two feedforward filter sections.

As is usual, the term data symbol transmission rate used herein means the number of data symbols transmitted per unit time from the transmitter, which value is assumed to be known by the receiver.

An embodiment of the invention will now be described, by way of example, with reference to the accompanying drawings, in which

Figure 1 is a schematic circuit diagram of a radio receiver front end comprising a prior art quadrature demodulator,

Figure 2 is a schematic circuit diagram of a quadrature demodulating arrangement in accordance with the invention,

Figure 3a shows the frequency response of a digital filter,

Figure 3b shows the frequency-translated response of the digital filter used in the circuit of Figure 2, and

Figures 4a and 4b are block schematic diagrams of filter sections used in the circuit of Figure 2.

The quadrature demodulating arrangement shown in Figure 2 may be incorporated in a radio receiver front end similar to that illustrated in Figure 1.

In this case however the IF output of AGC/limiter stage 7 is further down-converted at a second mixer stage 24 to a second intermediate frequency, by mixing with a signal of predetermined frequency from a local oscillator 25. Any suitable value may be selected for the first IF frequency, depending on the desired second IF and mixer stage requirements.

The second IF frequency $f_o$ is chosen to be equal to the data symbol transmission rate $f_s$, i.e. $f_o = f_s$.

The second IF signal output from mixer 24 is filtered by bandpass filter 26 and subsequently sampled by the sampler 27 and digitised by the ADC 28. The sampling rate is selected to be a factor of four times the data symbol transmission rate. Thus, for example four or eight times oversampling may be used. The resolution of ADC 28 may, for example, be 8 bits. In the present embodiment four times oversampling is used.

The output from ADC 28 is then applied to a complex digital filter 29. The filter 29 is a so-called finite impulse response (FIR) filter comprising R(z) as its real part 30 and I(z) as its imaginary part 31.

As is well-known when a real signal is down-converted to an IF frequency $f_o$, the resultant signal also has an image centred on $-f_o$. The principle of digital phase splitting employed in the present invention involves using as the complex digital filter 29 a real low-pass FIR and arranging that the passband coincides with the $+f_o$ image, but blocks the image at $-f_o$, resulting in a complex signal output, as will now be explained.

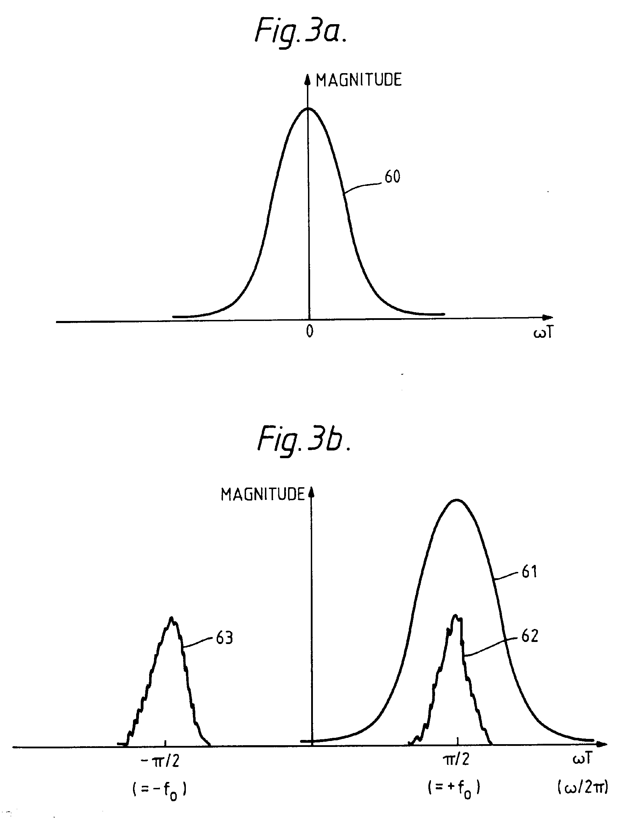

Figure 3a shows the frequency response of a general FIR filter. The pass band is centred on $\omega T = 0$, where T is the sampling period and $\omega$ is the angular frequency. The transfer function of the filter in the z domain, H(z), is given by

$$H(z) = \sum_{i=0}^{n} a_i \, z^{-i}$$

Translating this into the $\omega$ (frequency) domain i.e.

$$H(z) \rightarrow H(e^{j\omega T})$$

$$H(e^{j\omega T}) = \sum_{i=0}^{n} a_i \, e^{-j\omega T i}$$

Generally, the frequency response can be translated from $\omega$ to $\omega'$ by an amount $\omega_o$, i.e.

$$\omega' = \omega + \omega_o$$

Therefore,

$$\omega = (\omega' - \omega_o)$$

Hence

$$H(e^{j(\omega' - \omega_o)T}) = \sum_{i=0}^{n} a_i \, e^{-j(\omega' - \omega_o)Ti}$$

$$= \sum a_i \, e^{j\omega_o Ti} \, e^{-j\omega' Ti}$$

Therefore, the new z transform H'(z) of the frequency-translated filter is:

$$H'(z) = \sum_{i=0}^{n} a_i \, e^{j\omega_o iT} z^{-i} \quad \ldots\ldots\ldots(1)$$

It can thus be seen that each term of H(z) is modified by the factor $e^{j\omega_o iT}$.

Now,

$$T = 1/(f_{ADC})$$

where $f_{ADC}$ is the sampling rate at the ADC 28. If four times oversampling is used then

$$f_{ADC} = 4f_o$$

Therefore

$$T = 1/(4f_o) \quad (2)$$

If the frequency translation is chosen to be equal to a quarter of the ADC sampling rate , i.e. $(f_{ADC}/4) = f_o$ , then

$$\omega_o = 2\pi f_o \quad (3)$$

Substituting equations (2) and (3) into equation (1), we have

$$H'(z) = \Sigma a_i e^{ji\pi/2} z^{-i} \quad (4)$$

Figure 3b shows the frequency-translated spectrum 61 of the filter H'(z), in this particular case where the frequency translation is chosen to be equal to a quarter of the ADC sampling rate. It can be seen that the maximum frequency response now occurs at $\pi/2$ corresponding to a frequency $+f_o$. Figure 3b also shows the $+f_o$ spectral component 62 and the $-f_o$ spectral component 63 of the RF signal. Only the $+f_o$ component 62 is within the filter spectrum 61. In other words the pass band coincides with the $+f_o$ image, but the filter blocks the $-f_o$ image.

Referring back to equation (4) the terms of the summation fall alternately into real and imaginary values, as follows:

The first term, when i = 0, is

$$a_o \, e^{j0} z^{-0} = a_o$$

The second term, when i=1, is:

$$a_1 \, e^{j\pi/2} z^{-1} = j \, a_1 \, z^{-1}$$

The third term, when i=2, is:

$$a_2 e^{j\pi} z^{-2} = - a_2 \, z^{-2}$$

The fourth term, when i=3, is:

$$a_3 e^{j3\pi/2} z^{-2} = - ja_3 z^{-3}$$

The fifth term, when i=4, is:

$$a_4 \, e^{j2\pi} z^{-4} = a_4 z^{-4}$$

and so on for succeeding terms.

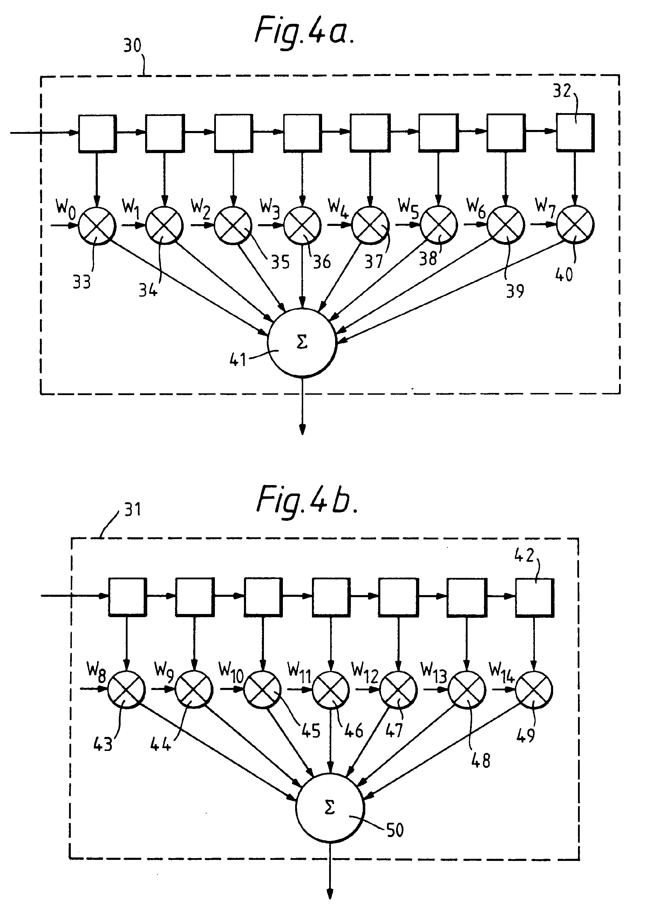

Thus it can be seen that the odd terms have pure real values, and the even terms have pure imaginary values. In this particular case (i.e. where the frequency response is shifted by a quarter of the ADC sampling rate), the digital filter splits cleanly into two distinct (smaller) feedforward filter sections 30, 31 associated respectively with real and imaginary parts R(z) and I(z), see Figure 2. The structure of the filter sections 30 and 31 is discussed in more detail below with reference to Figures 4a and 4b.

It is evident from the foregoing analysis that when the filter output is downsampled by $2^n$ only odd samples (i.e. when i takes an odd value) are needed for calculating Q and only even samples (i.e. when i takes an even value) are needed for calculating I. Therefore only the even samples are applied to feedforward filter section 30 and the odd samples are applied to feedforward filter section 31, as indicated in Figure 2.

The Applicant has used a fifteenth order FIR 29 comprising eight taps in the feedforward filter section 30 and seven taps in the feedforward filter section 31 as shown in Figures 4a and 4b respectively and discussed in more detail below. Depending on specific design circumstances the two filter sections may comprise more or less taps.

The desired I and Q signals are obtained by sampling the output of filter sections 30 and 31 at samplers 51 and 52 respectively. In the specific embodiment described here four times downsampling is preferably used, i.e. the output sampling rate is equal to the IF frequency $f_o = (f_{ADC}/4)$. In this case the complex signal is automatically output in IQ form. Alternative final sampling rates may be used as mentioned above, i.e. downsampling by $2^n$, but then further calculation may be required. For example, in the case of two times downsampling (i.e. final sampling rate = $2f_o$) each sample is rotated by $\pi$ and therfore alternate samples would have to be sign reversed to recover the I and Q components. In general, if the IF frequency $f_o$ is an integral multiple of the final sampling rate at samplers 51 and 52 then no sign reversal is necessary.

Referring now to Figure 4a, the feedforward filter section 30 comprises a transversal filter formed by a tapped delay line 32 comprising eight taps which are connected to respective multipliers 33 to 40 in which the signals derived are multiplied by respective weighting factors $W_0$ to $W_7$. In a specific embodiment the Applicant has used the following weighting coefficients quantized to 8 bits precision, viz. $W_0 = 4$, $W_1 = 0$, $W_2 = -12$ $W_3 = -72$, $W_4 = 72$, $W_5 = 12$, $W_6 = 0$, $W_7 = -4$. The multiplier outputs are summed in an addition stage 41, the output of which constitutes the I form of the signal.

Referring to Figure 4b, the feedforward filter section 31 similarly comprises a transversal filter formed by a tapped delay line 42 comprising seven taps connected to respective multipliers 43 to 49 in which the signals derived are multiplied by respective weighting factors $W_8$ to $W_{14}$. In conjunction with the specific weighting factors quoted above for the filter section 30, the Applicant has used the following weighting coefficients quantizied to 8 bits precision, viz. $W_8 = 8$, $W_9 = 14$, $W_{10} = 22$, $W_{11} = 96$, $W_{12} = 22$, $W_{13} = 14$, $W_{14} = 8$. The multiplier outputs are summed in an addition stage 50, the output of which constitutes the Q form of the signal.

In view of the foregoing, it will be evident to a person skilled in the art that various modifications may be made within the scope of the present invention. For example the various sampling rates may be selected according to particular circumstances and requirements. Furthermore the two feedforward filter sections may comprise fewer or more than fifteen taps depending on the specific filter characteristic (frequency response) desired. Also, the two filter sections may comprise an equal number of taps, or the filter section 31 may comprise an odd number of taps while the filter section 30 has an even number.

## Claims

1. A demodulating arrangement for deriving an in-phase (I) and quadrature (Q) output signal from an input radio frequency (RF) signal, comprising

   RF signal input means (24,25) for down-converting said RF signal to an intermediate frequency (IF) signal, the value of said intermediate frequency (IF) signal being equal to the data symbol transmission rate, wherein the data symbol transmission rate is the number of data symbols transmitted per unit time by the transmitter;

   means (27) for sampling said IF signal, said means being adapted to sample the IF signal at an integral multiple of four times the data symbol transmission rate,

   means (28) for digitising the sampled signal,

   digital filter means (29) comprising two feedforward filter sections (30 31), the digital filter means being adapted to pass a band of frequencies including the positive value of frequency ($+f_o$) corresponding to the frequency ($f_o$) of the IF signal and to attenuate a band of frequencies including the negative value of frequency ($-f_o$) corresponding to the frequency ($f_o$) of the IF signal; and

   means (29) for applying the digitised signal sample selectively to the two sections of said digital filter means whereby I and Q signals are output from the two filter sections respectively.

2. A demodulating arrangement as claimed in claim 1, wherein the digital filter means is adapted to pass a band of frequencies substantially centred on the positive value of frequency ($+f_o$) corresponding to the frequency ($f_o$) of the IF signal and to attenuate a band of frequencies substantially centred on the negative value of frequency ($-f_o$) corresponding to the frequency ($f_o$) of the IF signal.

3. A demodulating arrangement as claimed in any of the preceding claims, including means (51,52) for sampling the output from the two feedforward filter sections at a rate substantially equal to an integral multiple of the IF frequency ($f_o$).

4. A demodulating arrangement as claimed in any of the preceding claims, wherein the two sections of the digital filter means each comprise a tapped delay line (32, 42), having an unequal number of taps in each section.

5. A demodulating arrangement as claimed in claim 4, wherein one of the two sections of said digital filter means has one more tap than the other of the two sections of said filter means.

## Patentansprüche

1. Demodulationsvorrichtung zur Gewinnung eines Inphase- (I) und eines Quadratur- (Q) Ausgangssignals aus einem Eingangs- (HF) Hochfrequenzsignal, die umfaßt:
eine HF-Signal-Eingangseinrichtung (24,25) zur Abwärtswandlung des HF-Signals in ein Zwischenfrequenz- (ZF) Signal, wobei der Wert des ZF-Signals gleich der Datensymbol-Übertragungsrate ist und die Datensymbol-Übertragungsrate die Zahl von Datensymbolen ist, die pro Zeiteinheit von dem Sender übertragen wird,
eine Einrichtung (27) zum Abtasten des ZF-Signals, wobei die Einrichtung angepaßt ist, um das ZF-Signal mit einem ganzzahligen Vielfachen von viermal der Datensymbol-übertragungsrate abzutasten,
eine Einrichtung (28) zum Digitalisieren des abgetasteten Signals,
eine digitale Filtereinrichtung (29), die zwei Vorwärtskopplungs-Filterabschnitte (30,31) umfaßt, wobei die digitale Filtereinrichtung angepaßt ist, um ein Band von Frequenzen einschließlich des positiven Wertes der Frequenz $(+f_o)$ hindurchgehen zu lassen, das der Frequenz $(f_o)$ des ZF-Signals entspricht, und ein Band von Frequenzen einschließlich des negativen Wertes der Frequenz $(-f_o)$ abzuschwächen, das der Frequenz $(f_o)$ des ZF-Signals entspricht, und
eine Einrichtung (29), um die digitalisierte Signalabtastung selektiv an die zwei Abschnitte der digitalen Filtereinrichtung anzulegen, wodurch von den zwei Filterabschnitten I- bzw. Q-Signale ausgegeben werden.

2. Demodulationsvorrichtung nach Anspruch 1, bei der die digitale Filtereinrichtung angepaßt ist, um ein Band von Frequenzen hindurchgehen zu lassen, das im wesentlichen auf den positiven Wert der Frequenz $(+f_o)$, entsprechend der Frequenz fo des ZF-Signals, zentriert ist, und ein Band von Frequenzen abzuschwächen, das im wesentlichen auf den negativen Wert der Frequenz $(-f_o)$, entsprechend der Frequenz $(f_o)$ des ZF-Signals, zentriert ist.

3. Demodulationsvorrichtung nach einem der vorangehenden Ansprüche, mit einer Einrichtung (51,52), die den Ausgang von den zwei Vorwärtskopplungs-Filterabschnitten mit einer Rate abtastet, die im wesentlichen gleich einem ganzzahligen Vielfachen der ZF-Frequenz $(f_o)$ ist.

4. Demodulationsvorrichtung nach einem der vorangehenden Ansprüche, bei der die zwei Abschnitte der digitalen Filtereinrichtung je eine angezapfte Verzögerungsleitung (32,42) mit einer ungleichen Zahl von Anzapfungen in jedem Abschnitt umfassen.

5. Demodulationsvorrichtung nach Anspruch 4, bei der einer der zwei Abschnitte der digitalen Filtereinrichtung eine Anzapfung mehr besitzt als der andere der zwei Abschnitte der Filtereinrichtung.

## Revendications

1. Disposition de démodulation pour obtenir un signal de sortie en phase (I) et en quadrature (Q) à partir d'un signal haute fréquence (RF), comprenant
un moyen d'entrée de signal haute fréquence (24,25) pour convertir vers le bas ledit signal haute fréquence en un signal de fréquence intermédiaire (IF), la valeur dudit signal de fréquence intermédiaire (IF) étant égale à la vitesse de transmission des symboles de données, dans lequel la vitesse de transmission des symboles de données est le nombre de symboles de données transmis par unité de temps par l'émetteur,
un moyen (27) pour échantillonner ledit signal de fréquence intermédiaire, ledit moyen étant adapté pour échantillonner le signal de fréquence intermédiaire à un multiple entier de quatre fois la vitesse de transmission des symboles de données,
un moyen (28) pour numériser le signal échantillonné,
un moyen de filtre numérique (29) comprenant deux sections de filtres à précompensation (30, 31), le moyen de filtre numérique étant adapté pour laisser passer une bande de fréquence comprenant la valeur positive de fréquence ($+f_0$) correspondant à la fréquence ($f_0$) du signal de fréquence intermédiaire et pour atténuer une bande de fréquence comprenant la valeur négative de la fréquence ($-f_0$) correspondant à la fréquence ($f_0$) du signal de fréquence intermédiaire, et

un moyen (29) pour appliquer l'échantillon de signal numérisé sélectivement aux deux sections dudit moyen de filtres numériques, d'où il résulte que les signaux I et Q sont sortis à partir des deux sections de filtres, respectivement.

2. Disposition de démodulation, selon la revendication 1, dans laquelle le moyen de filtre numérique est adapté pour laisser passer une bande de fréquence essentiellement centrée sur la valeur positive de la fréquence ($+f_0$) correspondant à la fréquence ($f_0$) du signal de fréquence intermédiaire et pour atténuer une bande de fréquence essentiellement centrée sur la valeur négative de la fréquence ($-f_0$) correspondant à la fréquence ($f_0$) du signal de fréquence intermédiaire.

3. Disposition de démodulation selon l'une quelconque des revendications précédentes, comprenant un moyen (51, 52) pour échantillonner la sortie à partir des deux sections de filtres à précompensation à une vitesse essentiellement égale à un entier multiple de la fréquence intermédiaire ($f_0$).

4. Disposition de démodulation selon l'une quelconque des revendications précédentes, dans laquelle les deux sections du moyen de filtre numérique comprennent chacune une ligne de retard à prises (32, 42), comportant un nombre inégal de prises dans chaque section.

5. Disposition de démodulation selon la revendication 4, dans laquelle une des deux sections dudit moyen de filtre numérique comprend une prise de plus que l'autre des deux sections dudit moyen de filtre.

Fig.1.

Fig.2.

# Fig.3a.

# Fig.3b.

Fig.4a.

Fig.4b.